(19) Europäisches Patentamt / European Patent Office / Office européen des brevets

(11) **EP 2 878 573 B1**

(12) **FASCICULE DE BREVET EUROPEEN**

(45) Date de publication et mention de la délivrance du brevet:
**17.05.2017 Bulletin 2017/20**

(51) Int Cl.:
*B81B 3/00* (2006.01)      *F03G 3/00* (2006.01)
*G01C 9/00* (2006.01)      *G01D 5/12* (2006.01)
*G01P 15/08* (2006.01)

(21) Numéro de dépôt: **14195237.4**

(22) Date de dépôt: **27.11.2014**

(54) **Système masse-ressort à faible débattement transverse**

Masse-Feder-System mit schwacher Querauslenkung

Mass-spring system with small transverse displacement

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2013 FR 1361914**

(43) Date de publication de la demande:
**03.06.2015 Bulletin 2015/23**

(73) Titulaire: **COMMISSARIAT À L'ÉNERGIE ATOMIQUE ET AUX ÉNERGIES ALTERNATIVES**
**75015 Paris (FR)**

(72) Inventeurs:
 • **Boisseau, Sébastien**
  **38130 ECHIROLLES (FR)**
 • **Chaillout, Jean-Jacques**
  **38960 SAINT ETIENNE DE CROSSEY (FR)**
 • **Despesse, Ghislain**
  **38100 GRENOBLE (FR)**
 • **Duret, Alexandre-Benoit**
  **17600 SAUJON (FR)**

(74) Mandataire: **Thibon, Laurent**
 **Cabinet Beaumont**
 **1, rue Champollion**
 **38000 Grenoble (FR)**

(56) Documents cités:
**US-A1- 2012 320 439**

**Description**

Domaine

La présente description concerne un système masse-ressort, notamment un système masse-ressort ayant une fréquence de résonance inférieure à 50 Hz.

Exposé de l'art antérieur

Les systèmes masse-ressort peuvent être utilisés pour de nombreuses applications, notamment pour la réalisation d'un appareil de récupération d'énergie, d'un accéléromètre, d'un inclinomètre, d'un sismomètre, etc.

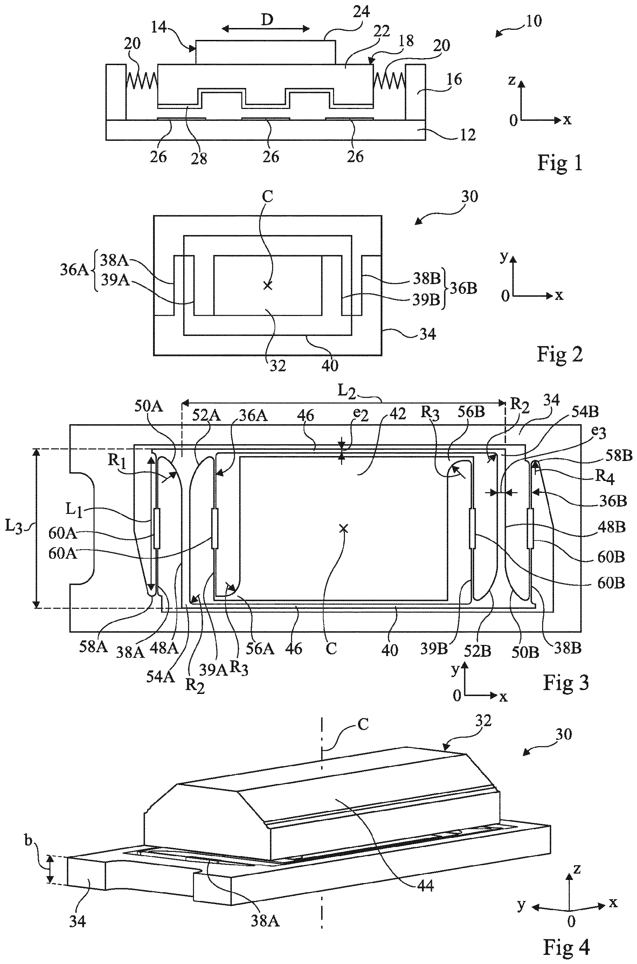

La figure 1 est une coupe latérale, partielle et schématique, d'un exemple d'un appareil de récupération d'énergie 10 mettant en oeuvre un microsystème électromécanique ou MEMS (Microelectromechanical Systems). Il s'agit, par exemple, d'un appareil 10 de récupération d'énergie vibratoire à convertisseur électrostatique à électrets. De tels appareils de récupération d'énergie vibratoire ont notamment pour but de convertir les vibrations ambiantes en électricité, notamment pour alimenter des systèmes peu consommateurs d'énergie, par exemple des capteurs autonomes ou des stimulateurs cardiaques. L'appareil 10 comprend une plaque 12, par exemple en un matériau diélectrique, notamment en verre, et un système masse-ressort 14 monté sur la plaque 12. Le système masse-ressort 14 comprend une masse 18 mobile par rapport à la plaque 12 et reliée par des ressorts 20 à un élément 16 fixe par rapport à la plaque 12. Les ressorts 20 permettent un déplacement de la masse mobile 18 par rapport à la plaque 12 selon une direction (Ox), qui est généralement horizontale. On appelle direction (Oz) la direction perpendiculaire à la direction (Ox) et à la face de la plaque 12 sur laquelle reposent les électrodes 26. La direction (Oz) correspond généralement à la direction verticale.

Le système masse-ressort 14 peut être formé en partie par gravure d'une plaque d'un matériau semi-conducteur, notamment du silicium. Dans ce cas, la masse mobile 18 peut comprendre une portion 22 de la plaque de silicium et une masse supplémentaire 24 fixée à la portion 22. Chaque ressort 20 peut comprendre des poutres rectilignes reliées en série et agencées en zigzag.

Des électrodes 26 sont prévues sur la plaque inférieure 12 en vis-à-vis de la portion mobile 22. Des électrets 28 peuvent être disposés sur la face de la portion mobile 22 en regard des électrodes 26. Les électrodes 26, la portion mobile 22 en matériau semi-conducteur et les électrets 28 forment un convertisseur électrostatique à électrets. Lorsque des vibrations sont appliquées à l'appareil 10, le système masse-ressort 14 convertit ces vibrations en un mouvement de va-et-vient de la masse mobile 18 selon la direction (Ox). Le mouvement relatif entre la portion mobile 22 et la plaque 12 entraîne la circulation d'un courant électrique dans une résistance de charge placée aux bornes du convertisseur électrostatique.

Pour le bon fonctionnement de l'appareil de récupération d'énergie 10, les électrodes 26 et les électrets 28 ne doivent pas venir au contact les uns des autres et, de préférence, l'écart entre les électrodes 26 et les électrets 28 doit rester sensiblement constant. Ceci signifie que le débattement de la masse mobile selon la direction (Oz) doit être le plus faible possible, en particulier nettement inférieur au déplacement possible selon la direction (Ox), par exemple selon un rapport 1/10 ou 1/100. En outre, pour que l'énergie fournie à chaque débattement par l'appareil de récupération d'énergie 10 soit la plus élevée possible, il est souhaitable que le débattement de la masse mobile 18 selon la direction (Ox) soit le plus élevé possible.

Pour permettre une récupération efficace des vibrations ambiantes, la fréquence de résonance du système masse-ressort doit être sensiblement égale à la fréquence de ces vibrations. Les vibrations ambiantes ont une fréquence qui est généralement inférieure à 50 Hz. Par conséquent, il est souhaitable que le système masse-ressort ait une fréquence de résonance basse, inférieure à 50 Hz, voire à 20 Hz. De telles fréquences de résonance sont faciles à atteindre avec des systèmes mécaniques classiques de grandes dimensions, notamment ayant une surface supérieure à 3 cm$^2$ dans un plan perpendiculaire à la direction (Oz). De telles fréquences de résonance sont beaucoup plus difficiles à obtenir avec des structures MEMS réalisées en silicium et de surfaces généralement inférieures à 3 cm$^2$. En effet, de telles structures MEMS nécessitent l'utilisation d'une masse mobile 18 dont le poids peut être supérieur à un gramme et de poutres formant les ressorts 20 ayant une largeur inférieure à 100 $\mu$m.

Ceci peut entraîner un enfoncement de la masse mobile 18 selon la direction (Oz) sous l'effet de son propre poids qui peut ne pas être compatible avec le bon fonctionnement de l'appareil 10, notamment par la mise en contact des électrodes 26 avec les électrets 28.

Le document US2012/320439 décrit un élément de réflexion optique comprenant un système masse-ressort.

Résumé

Un mode de réalisation vise à pallier tout ou partie des inconvénients des systèmes masse-ressort connus.

Un autre mode de réalisation vise à réduire le débattement vertical de la masse mobile du système masse-ressort.

Un autre mode de réalisation vise à augmenter le débattement longitudinal de la masse mobile du système masse-ressort.

Un autre mode de réalisation vise à obtenir un système masse-ressort dont la fréquence de résonance est inférieure à 50 Hz, voire à 20 Hz.

Un autre mode de réalisation vise un système masse-ressort pouvant être mis en oeuvre par un MEMS.

Ainsi, un mode de réalisation prévoit un système masse-ressort comprenant :

un support ;

une masse mobile par rapport au support ;

au moins un premier et un deuxième ressort reliant la masse au support et permettant un déplacement de la masse par rapport au support selon une première direction, le premier ressort étant le symétrique du deuxième ressort par rapport à un axe, chaque premier et deuxième ressort comprenant au moins des première et deuxième poutres en série agencées en zigzag ; et

un premier cadre fermé entourant la masse, à distance de la masse et du support, chaque première poutre comprenant une première extrémité reliée au support et une deuxième extrémité fixée au premier cadre et chaque deuxième poutre comprenant une troisième extrémité fixée au premier cadre et une quatrième extrémité reliée à la masse.

Selon un mode de réalisation, au moins l'une des premières et deuxièmes poutres comprend un renflement en partie médiane.

Selon un mode de réalisation, la longueur de chaque première et deuxième poutre est supérieure ou égale à 1 mm.

Selon un mode de réalisation, la hauteur de chaque première et deuxième poutre mesurée parallèlement à l'axe de symétrie est supérieure ou égale à 300 $\mu$m.

Selon un mode de réalisation, la largeur de chaque première et deuxième poutre mesurée perpendiculairement à la longueur dans un plan perpendiculaire à l'axe de symétrie est inférieure ou égale à 100 $\mu$m.

Selon un mode de réalisation, le premier cadre est relié à chaque première et deuxième poutre par une première portion arrondie dont le rayon de courbure est supérieur ou égal à dix fois ladite largeur.

Selon un mode de réalisation, la deuxième poutre est reliée à la masse par une deuxième portion arrondie dont le rayon de courbure est supérieur ou égal à dix fois ladite largeur.

Selon un mode de réalisation, le système comprend au moins un troisième et un quatrième ressort reliant la masse au support et permettant un déplacement de la masse par rapport au support selon la première direction, le troisième ressort étant le symétrique du quatrième ressort par rapport audit axe, chaque troisième et quatrième ressort comprenant au moins des troisième et quatrième poutres en série agencées en zigzag, chaque troisième poutre comprenant une troisième extrémité reliée au support et une quatrième extrémité fixée au premier cadre et chaque quatrième poutre comprenant une cinquième extrémité fixée au premier cadre et une sixième extrémité reliée à la masse.

Selon un mode de réalisation, le système comprend, pour chaque premier et deuxième ressort, au moins une cinquième poutre en série avec la deuxième poutre et en zig-zag avec la deuxième poutre, et un deuxième cadre fermé entourant la masse, à distance de la masse et du support, la quatrième extrémité de chaque deuxième poutre étant fixée au deuxième cadre et chaque cinquième poutre comprenant une septième extrémité fixée au deuxième cadre et une huitième extrémité reliée à la masse.

Selon un mode de réalisation, le système comprend, pour chaque premier et deuxième ressort, au moins une sixième poutre en série avec la cinquième poutre et en zig-zag avec la cinquième poutre, et un troisième cadre fermé entourant la masse, à distance de la masse et du support, la huitième extrémité de chaque cinquième poutre étant fixée au troisième cadre et chaque sixième poutre comprenant une neuvième extrémité fixée au troisième cadre et une dixième extrémité reliée à la masse.

Selon un mode de réalisation, le premier cadre suit une courbe fermée choisie parmi le groupe comprenant un rectangle, un cercle, une ellipse et une ligne brisée fermée.

Un mode de réalisation prévoit un appareil de récupération d'énergie comprenant un système masse-ressort tel que défini précédemment.

Un mode de réalisation prévoit un sismomètre comprenant un système masse-ressort tel que défini précédemment.

Un mode de réalisation prévoit un accéléromètre comprenant un système masse-ressort tel que défini précédemment.

Un mode de réalisation prévoit un inclinomètre comprenant un système masse-ressort tel que défini précédemment.

Un mode de réalisation prévoit un magnétomètre comprenant un système masse-ressort tel que défini précédemment, au moins une partie de la masse mobile étant composée d'un matériau ferromagnétique et/ou d'un aimant permanent.

Un mode de réalisation prévoit un capteur d'effort et/ou de déplacement comprenant un système masse-ressort tel que défini précédemment.

Brève description des dessins

Ces caractéristiques et avantages, ainsi que d'autres, sont exposés en détail dans la description suivante de modes de réalisation particuliers faite à titre non limitatif en relation avec les figures jointes parmi lesquelles :

la figure 1, décrite précédemment, est une coupe latérale, partielle et schématique, d'un exemple d'un appareil de récupération d'énergie ;
la figure 2 représente un schéma fonctionnel d'un mode de réalisation d'un système masse-ressort ;
les figures 3 et 4 sont respectivement une coupe et une vue en perspective d'un mode de réalisation d'un système masse-ressort selon le schéma fonctionnel de la figure 2 ;
la figure 5 est une vue de détail de la figure 3 ; et
les figures 6 à 13 représentent des schémas fonctionnels d'autres modes de réalisation d'un système masse-ressort.

Description détaillée

De mêmes éléments ont été désignés par de mêmes références aux différentes figures qui ont été tracées sans respect d'échelle. De plus, seuls les éléments utiles à la compréhension des modes de réalisation décrits sont représentés et détaillés. En particulier, les appareils utilisant les systèmes masse-ressort n'ont pas été illustrés en détail, de tels appareils étant bien connus de l'homme du métier. En outre, les procédés de fabrication de MEMS, notamment par gravure d'une plaque de silicium, sont bien connus de l'homme du métier et ne sont pas décrits en détail. De plus, on fait référence à des positions (supérieure, inférieure, latérale, etc.) en se basant de façon arbitraire sur l'orientation des figures. En outre, dans la suite de la description, les expressions "sensiblement", "environ" et "approximativement" signifient "à 10 % près".

Dans la suite de la description, des modes de réalisation d'un système masse-ressort adapté à la réalisation d'un appareil de récupération d'énergie vibratoire vont être décrits. Toutefois, le système masse-ressort selon les modes de réalisation décrits par la suite peut également être utilisé pour d'autres applications, par exemple pour la réalisation d'un inclinomètre, d'un accéléromètre ou d'un sismomètre, permettant notamment la détection de mouvements, de chocs et de vibrations à très basses fréquences ou la mesure d'inclinaisons très faibles, notamment par rapport au plan perpendiculaire à l'axe de la gravité. La masse sismique peut, en outre, être du type aimant permanent ou en matériaux ferriques et être susceptible de subir des efforts à l'approche d'un champ magnétique que l'on cherche à mesurer ou dont on cherche à récupérer de l'énergie. Le système masse-ressort peut aussi servir de capteur d'effort et/ou de déplacement. Il peut aussi servir de capteur de poids lorsqu'il est incliné par rapport à la gravité ou encore de capteur de vitesse/débit d'un fluide lorsqu'il est rattaché à une protubérance qui tend à être emportée par le fluide dans la direction (Ox). On mesure alors la force liée au frottement visqueux de la protubérance dans le liquide puis, par modélisation, on remonte à la vitesse d'écoulement du liquide ou au débit du liquide.

La figure 2 représente un schéma fonctionnel d'un mode de réalisation d'un système masse-ressort 30, adapté notamment à une utilisation pour réaliser un appareil de récupération d'énergie vibratoire. Le système masse-ressort 30 comprend une masse mobile 32 reliée par un nombre "a" de ressorts 36A, 36B, à un support 34, représenté schématiquement par un encadrement en figure 2. Les ressorts 36A, 36B sont adaptés à permettre le déplacement de la masse mobile 32 selon la direction (Ox) par rapport au support 34 en fonctionnement. Le nombre "a" de ressorts 36A, 36B est supérieur ou égal à 2. Dans le mode de réalisation représenté en figure 2, "a" est égal à 2. Dans la suite de la description, des éléments identiques associés aux deux ressorts 36A, 36B sont désignés par le même nombre suivi du suffixe "A" lorsque cet élément est associé au ressort 36A situé à gauche de la masse mobile 32 en figure 2 et du suffixe "B" lorsque cet élément est associé au ressort 36B situé à droite de la masse mobile 32 en figure 2.

Chaque ressort 36A ou 36B comprend au moins la mise en série d'un nombre "n" de poutres 38A, 39A ou 38B, 39B. Le nombre "n" de poutres 38A, 39A ou 38B, 39B est supérieur ou égal à 2. Dans le mode de réalisation représenté en figure 2, "n" est égal à 2. On appelle (Oy) la direction perpendiculaire à la direction (Ox) et (Oz), non représentée en figure 2, la direction perpendiculaire aux directions (Ox) et (Oy). A titre d'exemple, la direction (Oz) est verticale et le plan (Oxy) est un plan horizontal. Les poutres 38A, 38B, 39A, 39B formant les ressorts 36A, 36B s'étendent parallèlement à la direction (Oy) en l'absence de déformation.

Le système masse-ressort 30 comprend, en outre, un cadre de rigidification 40 constitué d'une pièce annulaire qui entoure complètement la masse mobile 32, à distance de la masse mobile 32 et du support 34. Le cadre de rigidification 40 est fixé aux ressorts 36A, 36B. Plus précisément, la première poutre 38A, 38B comprend une extrémité fixée au support 34 et une extrémité opposée fixée au cadre de rigidification 40. La deuxième poutre 39A, 39B comprend une extrémité fixée au cadre de rigidification 40 et une extrémité opposée fixée à la masse mobile 32. Le cadre de rigidification 40 se déplace selon la direction (Ox) lorsque la masse mobile 32 se déplace selon la direction (Ox). Le cadre de rigidification 40 ne se déforme sensiblement pas en fonctionnement.

Le système masse-ressort 30 comprend un axe de symétrie C parallèle à la direction (Oz), représenté par un point en figure 2. Le ressort 36A correspond au symétrique du ressort 36B selon la symétrie orthogonale dans l'espace par rapport à l'axe C. Le cadre de rigidification 40 a une structure symétrique selon la symétrie orthogonale par rapport à l'axe C. Par définition, la symétrie orthogonale par rapport à l'axe C est la transformation dans l'espace qui à tout point M non situé sur l'axe C, associe le point M' tel que l'axe C soit la médiatrice du segment [MM'].

Les inventeurs ont mis en évidence par simulation que le débattement important selon la direction (Oz) du système masse-ressort 10 pour une fréquence de résonnance inférieure à 50 Hz était en partie dû à la mise en torsion des poutres constituant les ressorts 20, notamment en raison de l'augmentation du poids de la masse mobile 18 et de la finesse, selon la direction (Ox), des poutres constituant les ressorts élémentaires 20. Dans le système masse-ressort 30 selon le présent mode de réalisation, le cadre de rigidification 40 permet de limiter la torsion des poutres 38A, 38B, 39A, 39B des ressorts 36A, 36B. Le débattement selon la direction (Oz) de la masse mobile 32 est alors réduit. Plus précisément, le cadre 40 permet d'empêcher que les zones des ressorts 36A, 36B auxquelles il est accroché ne présentent une rotation selon un axe de rotation parallèle à la direction (Oy) et au final d'avoir des poutres 38A, 39A ou 38B, 39B qui tendent à se déplacer selon la direction (Oz).

Les figures 3 et 4 sont respectivement une vue en coupe et une vue en perspective d'un mode de réalisation plus détaillé du système masse-ressort 30 selon le schéma fonctionnel de la figure 2. Le plan de coupe de la figure 3 est parallèle au plan (Oxy).

Dans ce mode de réalisation, les ressorts 36A, 36B, le support 34, le cadre de rigidification 40, et une portion 42 de la masse mobile 32 font partie d'une pièce monolithique formée par découpe et/ou gravure d'une plaque ayant une épaisseur H, par exemple une plaque en un matériau semi-conducteur, notamment en silicium, une plaque métallique, notamment en aluminium, en acier ou en tungstène, une plaque en plastique ou une plaque en céramique. A titre de variante, la pièce monolithique peut être réalisée par moulage.

La masse mobile 32 comprend la première portion 42 de la plaque dans laquelle les ressorts 36A, 36B, le support 34 et le cadre de rigidification 40 du système masse-ressort 30 sont formés et une deuxième portion 44, visible en figure 4, fixée à la première portion 42, par exemple par collage, et pouvant être en un matériau différent de celui de la première portion 42. A titre d'exemple, la deuxième portion 44 est en tungstène.

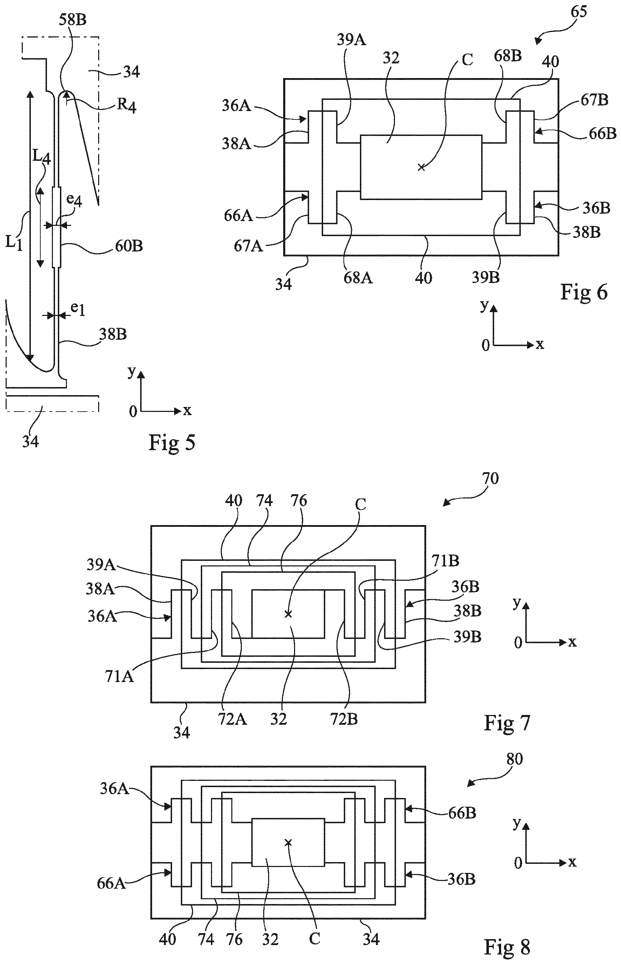

La figure 5 est une vue en coupe de détail de la poutre 38B. Les autres poutres 38A, 39B et 39A peuvent avoir la même structure que la poutre 38B.

Chaque poutre 38A, 38B, 39A, 39B a une longueur $L_1$ mesurée selon la direction (Oy). A titre d'exemple, les poutres 38A, 38B, 39A, 39B ont une section droite rectangulaire ayant une largeur $e_1$ mesurée selon la direction (Ox) et une hauteur b mesurée selon la direction (Oz) et visible en figure 4.

Dans le présent mode de réalisation, le cadre de rigidification 40 a une forme générale rectangulaire et comprend deux branches allongées 46 orientées parallèlement à la direction (Ox), de longueur $L_2$ mesurée selon la direction (Ox) et de largeur $e_2$ mesurée selon la direction (Oy), et deux branches allongées 48A, 48B orientées parallèlement à la direction (Oy), de longueur $L_3$ mesurée selon la direction (Oy) et de largeur $e_3$ mesurée selon la direction (Ox). Les longueurs $L_2$ et $L_3$ dépendent notamment des dimensions de la portion 42 de la masse mobile 32 et du débattement de la masse mobile 32 selon la direction (Ox).

Chaque branche 48A, 48B du cadre de rigidification 40 est reliée à la poutre 38A, 38B par une portion arrondie 50A, 50B et à la poutre 39A, 39B par une portion arrondie 52A, 52B, chaque portion arrondie 50A, 50B, 52A, 52B ayant un rayon de courbure $R_1$. Du côté opposé à la liaison entre la branche 48A, 48B et les poutres 38A, 38B, 39A, 39B, la branche 48A, 48B est reliée à la branche 46 par une portion arrondie 54A, 54B ayant un rayon de courbure $R_2$.

Chaque poutre 39A, 39B est reliée à la portion 42 de la masse mobile 32 par une portion arrondie 56A, 56B ayant un rayon de courbure $R_3$. Chaque poutre 38A, 38B est reliée au support 34 par une portion arrondie 58A, 58B ayant un rayon de courbure $R_4$.

Comme cela est visible en figure 5, chaque poutre 38A, 38B, 39A, 39B peut comprendre une portion renforcée 60A, 60B, par exemple située sensiblement en partie médiane, ayant une longueur $L_4$ et une largeur $e_4$ strictement supérieure à $e_1$.

En appelant E le module d'Young du matériau constituant les ressorts 36A, 36B, la constante de raideur $k_e$ de chaque poutre 38A, 38B, 39A, 39B est donnée par la relation (1) suivante :

$$k_e = \frac{E.b.e_1^{\,3}}{L_1^{\,3}} \qquad\qquad (1)$$

La raideur $k_T$ de l'ensemble du système masse-ressort 30 est donnée par la relation (2) suivante :

$$k_T \;=\; \frac{a}{n}\, k_e \;=\; \frac{a}{n}\, \frac{E.b.e_1^{\,3}}{L_1^{\,3}} \qquad\qquad (2)$$

Pour obtenir la fréquence de résonance $f_0$ souhaitée du système masse-ressort 30, la longueur $L_1$ et la largeur $e_1$ doivent respecter la relation (3) suivante :

$$\frac{L_1}{e_1} \;=\; \left( \frac{a}{n}\, \frac{E.b}{m(2\pi.f_0^{\,2})} \right)^{3/2} \qquad\qquad (3)$$

Le débattement de la masse mobile 32 selon la direction (Oz) est inférieur à quelques micromètres alors que le débattement de la masse mobile 32 selon la direction (Ox) peut être supérieur à quelques millimètres, notamment pour un niveau d'accélération statique autour de 9,81 m.s$^{-2}$ selon la direction (Oz) ou (Ox). Cette structure permet d'atteindre une raideur selon la direction (Oz) jusqu'à plus de 100 fois supérieure à la raideur selon la direction (Ox).

Des exemples de dimensions dans le cas où les ressorts 36A, 36B, le support 34, le cadre de rigidification 40, et la portion 42 de la masse mobile 32 correspondent à une pièce monolithique formée par gravure d'une plaque d'un matériau semi-conducteur, notamment du silicium dont le module d'Young est de 130 GPa, et permettant d'obtenir une fréquence de résonnance inférieure ou égale à 20 Hz, sont les suivante :

- masse de la masse mobile 32 : supérieure ou égale à 1 g, par exemple environ 1,36 g ;
- longueur $L_1$: supérieure ou égale à 1 mm, de préférence supérieure ou égale à 2 mm, plus préférentiellement supérieure ou égale à 3 mm, par exemple environ 4 mm ;
- largeur $e_1$ : inférieure ou égale à 50 $\mu$m, de préférence inférieure ou égale à 30 $\mu$m, plus préférentiellement inférieure ou égale à 25 $\mu$m, par exemple environ 22 $\mu$m ;
- hauteur b : supérieure ou égale à 300 $\mu$m, de préférence supérieure ou égale à 500 $\mu$m, plus préférentiellement supérieure ou égale à 600 $\mu$m, par exemple environ 700 $\mu$m ;
- longueur $L_2$ : supérieure ou égale à 5 mm, préférentiellement supérieure à 8 mm, par exemple, 8,5 mm ;
- largeurs $e_2$, $e_3$ : comprises entre 0,1 et 100 fois $e_1$, de préférence entre 5 et 10 fois $e_1$, par exemple environ 0,2 mm ;
- longueur $L_3$ : proche de $L_1$, de préférence supérieure à $L_1$ de 100 $\mu$m à 500 $\mu$m, par exemple supérieure à $L_1$ de 350 $\mu$m ;
- largeur $e_3$ : environ 0,2 mm ;
- longueur $L_4$ : supérieure ou égale à $L_1/5$, par exemple environ $L_1/4$ ;
- largeur $e_4$: supérieure ou égale à $2*e_1$, de préférence supérieure ou égale à $3*e_1$, par exemple environ 0,06 mm ;
- rayon de courbure $R_1$ : supérieur ou égal à 0,1 mm, de préférence supérieur à 1 mm, par exemple environ 1,5 mm ;
- rayon de courbure $R_2$ : supérieur ou égal à 0,1 mm ;
- rayon de courbure $R_3$ : supérieur ou égal à 0,1 mm, de préférence supérieur ou égal à 0,2 mm, plus préférentiellement supérieur ou égal à 0,5 mm ; et
- rayon de courbure $R_4$ : supérieur ou égal à $10*e_1$.

Le cadre de rigidification 40 fermé limite la torsion des poutres 38A, 38B, 39A, 39B autour de l'axe (Oy). Ceci permet de limiter l'enfoncement de la masse mobile 32 selon la direction (Oz) sous son propre poids. Les portions de renfort 60A, 60B participent également à empêcher la torsion des poutres 38A, 38B, 39A, 39B autour de l'axe (Oy) mais dans une moindre mesure que le cadre de rigidification 40.

La présence du cadre de rigification 40 et des portions de renfort 60A, 60B ne modifie que très légèrement la fréquence de résonance $f_0$ du système masse-ressort 30, par exemple de 5 à 10 %.

La figure 6 représente un schéma fonctionnel d'un autre mode de réalisation d'un système masse-ressort 65, dans lequel le nombre de ressorts "a" est doublé par rapport au système masse-ressort 30 représenté en figure 2. En plus des ressorts 36A, 36B, le système masse-ressort 65 comprend deux ressorts supplémentaires 66A, 66B qui sont symétriques l'un de l'autre par rapport à l'axe C. En outre, dans l'exemple représenté, le ressort 36A est symétrique du ressort 66B par rapport à un plan parallèle au plan (0yz) contenant l'axe C, et le ressort 66A est symétrique du ressort 36B par rapport à ce plan. Chaque ressort 66A, 66B comprend une succession d'une première poutre 67A, 67B et d'une deuxième poutre 68A, 68B. Le cadre de rigidification 40 est fixé aux ressorts 36A, 36B, comme cela a été décrit précédemment, et, en outre, aux ressorts 66A, 66B. Plus précisément, la poutre 67A, 67B comprend une extrémité fixée au support 34 et une extrémité opposée fixée au cadre de rigidification 40. La deuxième poutre 68A, 68B comprend une extrémité fixée au cadre de rigidification 40 et une extrémité opposée fixée à la masse mobile 32. La raideur $k_T$ du système masse-ressort 65 est supérieure à la raideur du système masse-ressort 30 pour le même encombrement. Elle peut être calculée en utilisant la relation (2) en prenant "a" égal à 4 et "n" égal à 2. Cette configuration permet de limiter encore plus l'enfoncement de la masse mobile que la configuration représentée en figure 3. Plus précisément, cette configuration ne permet pas d'augmenter le rapport entre les raideurs selon les directions (Oz) et (Ox), étant donné que les deux raideurs sont augmentées du même ordre. Par contre, elle permet de limiter la rotation de la masse sismique 32 selon un axe parallèle à la direction (Ox).

La figure 7 représente un schéma fonctionnel d'un autre mode de réalisation d'un système masse-ressort 70 dans lequel le nombre de ressorts "a" est égal à 2 et le nombre "n" de poutres par ressort est égal à 4. Par rapport au système masse-ressort 30 représenté en figure 2, le système masse-ressort 70 comprend, en outre, pour chaque ressort 36A, 36B, deux poutres supplémentaires 71A, 71B, 72A, 72B. En outre, le système masse-ressort 70 comprend deux cadres de rigidification supplémentaires 74, 76 en plus du cadre de rigidification 40. Chaque cadre 40, 74, 76 correspond à un cadre fermé entourant en totalité la masse mobile 32 et fixé aux ressorts 36A, 36B. Le cadre de rigidification 40 est fixé aux poutres 38A, 38B, 39A, 39B comme cela a été décrit précédemment. Toutefois, à la différence du système masse-ressort 30, la poutre 39A, 39B n'est pas fixée à la masse mobile 32 mais au cadre de rigidification 74. La poutre 71A, 71B comprend une extrémité fixée au cadre de rigidification 74 et une extrémité opposée fixée au cadre de rigidification 76. La poutre 72A, 72B comprend une extrémité fixée au cadre de rigidification 76 et une extrémité opposée fixée à la masse mobile 32. La raideur $k_T$ du système masse-ressort 70 est inférieure à la raideur du système masse-ressort 30 pour le même encombrement. La raideur peut se déduire de la relation (2) avec "a" égal à 2 et "n" égal à 4. Cette configuration permet de diminuer les contraintes mécaniques, dans le matériau constituant les poutres, pour un déplacement et une surface donnés ou d'augmenter le déplacement de la masse mobile pour une contrainte mécanique maximale donnée.

La figure 8 représente un schéma fonctionnel d'un autre mode de réalisation d'une structure masse-ressort 80 dans lequel le nombre de ressorts "a" est égal à 4 et le nombre de poutres par ressort "n" est égal à 4. Le système masse-ressort 80 correspond donc à la combinaison des caractéristiques du système masse-ressort 60 et du système masse-ressort 70.

La raideur $k_T$ du système masse-ressort 80 est supérieure à la raideur du système masse-ressort 30 pour un encombrement donné. Toutefois, le débattement selon la direction (Ox) pouvant être obtenu avec le système masse-ressort 80 est supérieur à celui qui peut être obtenu avec le système masse-ressort 30 pour une contrainte mécanique maximale donnée dans le matériau constituant la poutre.

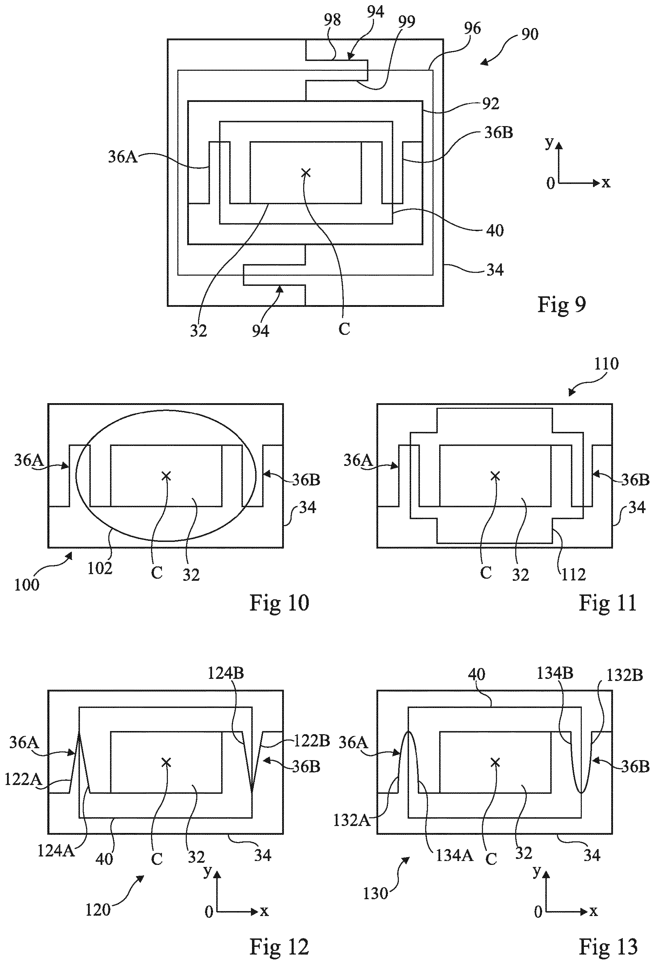

La figure 9 représente un schéma fonctionnel d'un autre mode de réalisation d'un système masse-ressort 90 qui permet un débattement de la masse mobile 32 à la fois selon la direction (Ox) et la direction (Oy).

Dans ce but, par rapport au système masse-ressort 30 représenté en figure 2, les poutres 37A, 37B ne sont pas fixées au support 34 mais à un cadre intermédiaire 92 fermé qui entoure complètement le cadre de rigidification 40. Le cadre intermédiaire 92 est relié au support 34 par au moins deux ressorts 94. Les ressorts 94 permettent le débattement de la masse mobile 32 selon la direction (Oy). Les ressorts 94 répondent aux mêmes contraintes que les ressorts 36A, 36B. En particulier, ils sont symétriques l'un de l'autre par la symétrie orthogonale par rapport à l'axe C. En outre, il est prévu un cadre de rigidification supplémentaire 96 fermé entourant complètement le cadre intermédiaire 92 et fixé aux ressorts 94. Plus précisément, chaque ressort 94 est constitué d'au moins deux poutres 98, 99 s'étendant parallèlement à la direction (Ox) en l'absence de déformation. La poutre 98 comprend une extrémité fixée au support 34 et une extrémité opposée fixée au cadre de rigidification 96. La poutre 99 comprend une extrémité fixée au cadre de rigidification 96 et une extrémité opposée fixée au cadre intermédiaire 96.

Dans les modes de réalisation décrits précédemment, la courbe moyenne suivie par le cadre de rigidification 40 a, en vue de dessus, une forme générale rectangulaire. Toutefois, d'autres formes de courbes moyennes peuvent être utilisées.

Les figures 10 et 11 représentent chacune un schéma fonctionnel d'un autre mode de réalisation d'un système masse-ressort 100 dans lequel le cadre de rigidification 40 du système masse-ressort 30 de la figure 2 est remplacé par un cadre de rigidification 102 qui suit une courbe moyenne fermée ayant la forme d'une ellipse (figure 10) ou d'une ligne brisée (figure 11). D'autres formes, telles qu'un cercle, peuvent être utilisées.

Dans les modes de réalisation décrits précédemment, chaque poutre 38A, 38B, 39A, 39B correspond à une poutre droite s'étendant selon la direction (Oy) en l'absence de déformation. Toutefois, d'autres agencements de poutres droites peuvent être utilisés.

La figure 12 représente un mode de réalisation d'un système masse-ressort 120 dans lequel les poutres 38A, 38B, 39A, 39B du système masse-ressort 30 représenté en figure 2 sont remplacées par des poutres 122A, 122B, 124A, 124B correspondant chacun à une poutre droite inclinée par rapport aux directions (Oy) et (Ox). Chaque paire de poutres 122A, 124A et 122B, 124B forme un "V".

Dans les modes de réalisation décrits précédemment, chaque poutre 38A, 38B, 39A, 39B correspond à une poutre droite. Toutefois, d'autres types de poutres peuvent être utilisés.

La figure 13 représente un mode de réalisation d'un système masse-ressort 130 dans lequel les poutres 38A, 38B, 39A, 39B du système masse-ressort 30 représenté en figure 2 sont remplacées par des poutres 132A, 132B, 134A, 134B correspondant chacune à une poutre dont la courbe moyenne n'est pas une droite.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, le mode de réalisation représenté en figure 9 peut être mis en oeuvre avec l'un quelconque des modes de réalisation décrits en relation avec les figures 2, 6 à 8 et 10 à 13. En outre, le mode de réalisation représenté en figure 10 ou 11 peut être mis en oeuvre avec l'un quelconque des modes de réalisation décrits en relation avec les figures 2, 6 à 9, 12 et 13. De plus, le mode de réalisation représenté en figure 12 ou 13 peut être mis en oeuvre avec l'un quelconque des modes de réalisation décrits en relation avec les figures 2 et 6 à 11.

**Revendications**

1. Système masse-ressort (30) comprenant :

   un support (34) ;
   une masse (32) mobile par rapport au support ;
   au moins un premier et un deuxième ressort (36A, 36B) reliant la masse au support et permettant un déplacement de la masse par rapport au support selon une première direction (Ox), le premier ressort étant le symétrique du deuxième ressort par rapport à un axe (C), chaque premier et deuxième ressort comprenant au moins des première et deuxième poutres (38A, 38B, 39A, 39B) en série agencées en zigzag ; et
   un premier cadre fermé (40) entourant la masse, à distance de la masse et du support,
   **caractérisé en ce que** chaque première poutre (38A, 38B) comprend une première extrémité reliée au support et une deuxième extrémité fixée au premier cadre et **en ce que** chaque deuxième poutre (39A, 39B) comprend une troisième extrémité fixée au premier cadre et une quatrième extrémité reliée à la masse.

2. Système masse-ressort selon la revendication 1, dans lequel au moins l'une des premières et deuxièmes poutres (38A, 38B, 39A, 39B) comprend un renflement (60A, 60B) en partie médiane.

3. Système masse-ressort selon la revendication 1 ou 2, dans lequel la longueur ($L_1$) de chaque première et deuxième poutre (38A, 38B, 39A, 39B) est supérieure ou égale à 1 mm.

4. Système masse-ressort selon l'une quelconque des revendications 1 à 3, dans lequel la hauteur de chaque première et deuxième poutre (38A, 38B, 39A, 39B) mesurée parallèlement à l'axe de symétrie (C) est supérieure ou égale à 300 $\mu$m.

5. Système masse-ressort selon les revendications 3 et 4, dans lequel la largeur ($e_1$) de chaque première et deuxième poutre (38A, 38B, 39A, 39B) mesurée perpendiculairement à la longueur dans un plan perpendiculaire à l'axe de symétrie est inférieure ou égale à 100 $\mu$m.

6. Système masse-ressort selon la revendication 5, dans lequel le premier cadre (40) est relié à chaque première et deuxième poutre (38A, 38B, 39A, 39B) par une première portion arrondie (50A, 52A, 50B, 52B) dont le rayon de courbure ($R_1$) est supérieur ou égal à dix fois ladite largeur ($e_1$).

7. Système masse-ressort selon la revendication 5, dans lequel la deuxième poutre (39A, 39B) est reliée à la masse (32) par une deuxième portion arrondie (56A, 56B) dont le rayon de courbure ($R_3$) est supérieur ou égal à dix fois ladite largeur ($e_1$).

8. Système masse-ressort selon l'une quelconque des revendications 1 à 7, comprenant au moins un troisième et un quatrième ressort (66A, 66B) reliant la masse (32) au support (34) et permettant un déplacement de la masse par rapport au support selon la première direction (Ox), le troisième ressort étant le symétrique du quatrième ressort par rapport audit axe (C), chaque troisième et quatrième ressort comprenant au moins des troisième et quatrième poutres (67A, 67B, 68A, 68B) en série agencées en zigzag, chaque troisième poutre comprenant une troisième extrémité reliée au support et une quatrième extrémité fixée au premier cadre et chaque quatrième poutre comprenant une cinquième extrémité fixée au premier cadre et une sixième extrémité reliée à la masse.

9. Système masse-ressort selon l'une quelconque des revendications 1 à 8, comprenant, pour chaque premier et deuxième ressort (36A, 36B), au moins une cinquième poutre (71A, 71B) en série avec la deuxième poutre (39A, 39B) et en zig-zag avec la deuxième poutre, et un deuxième cadre (74) fermé entourant la masse (32), à distance de la masse et du support (34), la quatrième extrémité de chaque deuxième poutre (39A, 39B) étant fixée au deuxième cadre (74) et chaque cinquième poutre (71A, 71B) comprenant une septième extrémité fixée au deuxième cadre et une huitième extrémité reliée à la masse.

10. Système masse-ressort selon la revendication 9, comprenant, pour chaque premier et deuxième ressort (36A, 36B), au moins une sixième poutre (72A, 72B) en série avec la cinquième poutre (71A, 71B) et en zig-zag avec la cinquième poutre, et un troisième cadre (76) fermé entourant la masse (32), à distance de la masse et du support (34), la huitième extrémité de chaque cinquième poutre étant fixée au troisième cadre et chaque sixième poutre (72A, 72B) comprenant une neuvième extrémité fixée au troisième cadre et une dixième extrémité reliée à la masse.

11. Système masse-ressort selon l'une quelconque des revendications 1 à 10, dans lequel le premier cadre suit une courbe fermée choisie parmi le groupe comprend un rectangle, un cercle, une ellipse et une ligne brisée fermée.

12. Appareil de récupération d'énergie comprenant un système masse-ressort (30) selon l'une quelconque des revendications 1 à 11.

13. Sismomètre comprenant un système masse-ressort (30) selon l'une quelconque des revendications 1 à 11.

14. Accéléromètre comprenant un système masse-ressort (30) selon l'une quelconque des revendications 1 à 11.

15. Inclinomètre comprenant un système masse-ressort (30) selon l'une quelconque des revendications 1 à 11.

16. Magnétomètre comprenant un système masse-ressort (30) selon l'une quelconque des revendications 1 à 11 et dans lequel au moins une partie de la masse (32) est composée d'un matériau ferromagnétique et/ou d'un aimant permanent.

17. Capteur d'effort et/ou de déplacement comprenant un système masse-ressort (30) selon l'une quelconque des revendications 1 à 11.

**Patentansprüche**

1. Feder-Masse-System (30), welches Folgendes aufweist:

   eine Tragstruktur (34);
   eine Masse (32), die bezüglich der Tragstruktur bewegbar ist;
   zumindest eine erste und eine zweite Feder (36A, 36B), welche die Masse mit der Tragstruktur verbinden und eine Verschiebung der Masse relativ zur Tragstruktur entlang einer ersten Richtung (Ox) gestatten, wobei die erste Feder symmetrisch zur zweiten Feder bezüglich einer Achse (C) ist, wobei sowohl die erste als auch die zweite Feder zumindest erste und zweite in Reihe verbundene Träger (38A, 38B, 39A, 39B) aufweisen, die im Zickzack angeordnet sind; und
   einen ersten geschlossenen Rahmen (40), der die Masse in einer Distanz von der Masse und der Tragstruktur umgibt,
   **dadurch gekennzeichnet, dass** jeder erste Träger (38A, 38B) ein erstes Ende aufweist, welches mit der Tragstruktur verbunden ist, und ein zweites Ende, welches an dem ersten Rahmen angebracht ist, und dadurch, dass jeder zweite Träger (39A, 39B) ein drittes Ende aufweist, welches an dem ersten Rahmen angebracht ist, und ein viertes Ende, welches mit der Masse verbunden ist.

2. Feder-Masse-System nach Anspruch 1, wobei zumindest einer der ersten und zweiten Träger (38A, 38B, 39A, 39B) eine Verdickung (60A, 60B) in seinem mittleren Bereich aufweist.

3. Feder-Masse-System nach Anspruch 1 oder 2, wobei die Länge ($L_1$) von jedem der ersten und zweiten Träger (38A, 38B, 39A, 39B) größer oder gleich 1 mm ist.

4. Feder-Masse-System nach einem der Ansprüche 1 bis 3, wobei die Höhe von jedem der ersten und zweiten Träger (38A, 38B, 39A, 39B), gemessen parallel zu der Symmetrieachse (C) größer oder gleich 300 $\mu$m ist.

5. Feder-Masse-System nach einem der Ansprüche 3 und 4, wobei die Breite ($e_1$) von jedem ersten und zweiten Träger (38A, 38B, 39A, 39B), gemessen senkrecht zur Länge in einer Ebene senkrecht zur Symmetrieachse, kleiner oder gleich 100 $\mu$m ist.

6. Feder-Masse-System nach Anspruch 5, wobei der erste Rahmen (40) mit jedem ersten und zweiten Träger (38A, 38B, 39A, 39B) durch einen ersten abgerundeten Teil (50A, 52A, 50B, 52B) mit einem Krümmungsradius ($R_1$) verbunden ist, der größer oder gleich zehnmal der Breite ($e_1$) ist.

7. Feder-Masse-System nach Anspruch 5, wobei der zweite Träger (39A, 39B) mit der Masse (32) durch einen zweiten abgerundeten Teil (56A, 56B) mit einem Krümmungsradius ($R_3$) verbunden ist, der größer oder gleich zehnmal der Breite ($e_1$) ist.

8. Feder-Masse-System nach einem der Ansprüche 1 bis 7, welches zumindest eine dritte und eine vierte Feder (66A, 66B) aufweist, welche die Masse (32) mit der Tragstruktur (34) verbinden und eine Verschiebung der Masse bezüglich der Tragstruktur entlang der ersten Richtung (Ox) gestatten, wobei die dritte Feder symmetrisch zur vierten Feder bezüglich der Achse (C) ist, wobei jede dritte und vierte Feder zumindest dritte und vierte in Reihe verbundene Träger (67A, 67B, 68A, 68B) aufweist, die im Zickzack angeordnet sind, wobei jeder dritte Träger ein drittes Ende aufweist, welches mit der Tragstruktur verbunden ist, und ein viertes Ende, welches an dem ersten Rahmen angebracht ist, und wobei jeder vierte Träger ein fünftes Ende aufweist, welches an dem ersten Rahmen angebracht ist, und ein sechstes Ende, welches mit der Masse verbunden ist.

9. Feder-Masse-System nach einem der Ansprüche 1 bis 8, welches für jede erste und zweite Feder (36A, 36B) zumindest einen fünften Träger (71A, 71 B) in Reihe mit dem zweiten Träger (39A, 39B) und in Zickzackanordnung mit dem zweiten Träger aufweist, und einen zweiten geschlossenen Rahmen (74), welcher die Masse (32) umgibt, und zwar in einer Distanz von der Masse und der Tragstruktur (34), wobei das vierte Ende von jedem zweiten Träger (39A, 39B) an den zweiten Rahmen (74) angebracht ist, und wobei jeder fünfte Träger (71A, 71 B) ein siebtes Ende aufweist, welches an dem zweiten Rahmen angebracht ist, und ein achtes Ende, welches mit der Masse verbunden ist.

10. Feder-Masse-System nach Anspruch 9, welches für jede erste und zweite Feder (36A, 36B) zumindest einen sechsten Träger (72A, 72B) in Reihe mit dem fünften Träger (71A, 71B) und in Zickzackanordnung mit dem fünften Träger aufweist, und einen dritten geschlossenen Rahmen (76), welcher die Masse (32) umgibt, und zwar in einer Distanz zur Masse und der Tragstruktur (34), wobei das achte Ende von jedem fünften Träger an dem dritten Rahmen angebracht ist, und wobei jeder sechste Träger (72A, 72B) ein neuntes Ende aufweist, welches an dem dritten Rahmen angebracht ist, und ein zehntes Ende, welches mit der Masse verbunden ist.

11. Feder-Masse-System nach einem der Ansprüche 1 bis 10, wobei der erste Rahmen einer geschlossenen Kurve folgt, die aus der Gruppe ausgewählt ist, die ein Rechteck, einen Kreis, eine Ellipse und eine geschlossene unterbrochene Linie aufweist.

12. Energiewiedergewinnungsvorrichtung, welche das Feder-Masse-System (30) nach einem der Ansprüche 1 bis 11 aufweist.

13. Seismometer, welches das Feder-Masse-System (30) nach einem der Ansprüche 1 bis 11 aufweist.

14. Beschleunigungsmesser, welcher das Feder-Masse-System (30) nach einem der Ansprüche 1 bis 11 aufweist.

15. Neigungsmesser, welcher das Feder-Masse-System (30) nach einem der Ansprüche 1 bis 11 aufweist.

16. Magnetometer, welches das Feder-Masse-System (30) nach einem der Ansprüche 1 bis 11 aufweist, und wobei zumindest ein Teil der Masse (32) aus einem ferromagnetischen Material und/oder aus einem Permanentmagneten geformt ist.

17. Kraft- und/oder Verschiebungssensor, welcher das Feder-Masse-System (30) nach einem der Ansprüche 1 bis 11 aufweist.

**Claims**

1. A spring-mass system (30) comprising:

   a support (34);
   a mass (32) mobile with respect to the support;
   at least one first and one second spring (36A, 36B) connecting the mass to the support and allowing a displacement of the mass relative to the support along a first direction (Ox), the first spring being the symmetrical of the second spring with respect to an axis (C), each first and second spring comprising at least first and second series-connected beams (38A, 38B, 39A, 39B) arranged in zigzag; and
   a first closed frame (40) surrounding the mass, at a distance from the mass and the support, **characterized in that** each first beam (38A, 38B) comprises a first end connected to the support and a second end attached to the first frame, and **in that** each second beam (39A, 39B) comprises a third end attached to the first frame and a fourth end connected to the mass.

2. The spring-mass system of claim 1, wherein at least one of the first and second beams (38A, 38B, 39A, 39B) comprises a bulge (60A, 60B) in its median portion.

3. The spring-mass system of claim 1 or 2, wherein the length ($L_1$) of each first and second beam (38A, 38B, 39A, 39B) is greater than or equal to 1 mm.

4. The spring-mass system of any of claims 1 to 3, wherein the height of each first and second beam (38A, 38B, 39A, 39B) measured parallel to the axis of symmetry (C) is greater than or equal to 300 $\mu$m.

5. The spring-mass system of any of claims 3 and 4, wherein the width ($e_1$) of each first and second beam (38A, 38B, 39A, 39B) measured perpendicularly to the length in a plane perpendicular to the axis of symmetry is smaller than or equal to 100 $\mu$m.

6. The spring-mass system of claim 5, wherein the first frame (40) is connected to each first and second beam (38A, 38B, 39A, 39B) by a first rounded portion (50A, 52A, 50B, 52B) having a radius of curvature ($R_1$) greater than or equal to ten times said width ($e_1$).

7. The spring-mass system of claim 5, wherein the second beam (39A, 39B) is connected to the mass (32) by a second rounded portion (56A, 56B) having a radius of curvature ($R_3$) greater than or equal to ten times said width ($e_1$).

8. The spring-mass system of any of claims 1 to 7, comprising at least one third and one fourth spring (66A, 66B) connecting the mass (32) to the support (34) and allowing a displacement of the mass with respect to the support along the first direction (Ox), the third spring being the symmetrical of the fourth spring with respect to said axis (C), each third and fourth spring comprising at least third and fourth series-connected beams (67A, 67B, 68A, 68B) arranged in zigzag, each third beam comprising a third end connected to the support and a fourth end attached to the first frame and each fourth beam comprising a fifth end attached to the first frame and a sixth end connected to the mass.

9. The spring-mass system of any of claims 1 to 8, comprising, for each first and second spring (36A, 36B), at least one fifth beam (71A, 71B) in series with the second beam (39A, 39B) and in zigzag with the second beam, and a second closed frame (74) surrounding the mass (32), at a distance from the mass and the support (34), the fourth end of each second beam (39A, 39B) being attached to the second frame (74) and each fifth beam (71A, 71B) comprising a seventh end attached to the second frame and an eighth end connected to the mass.

10. The spring-mass system of claim 9, comprising, for each first and second spring (36A, 36B), at least one sixth beam (72A, 72B) in series with the fifth beam (71A, 71B) and in zigzag with the fifth beam, and a third closed frame (76) surrounding the mass (32), at a distance from the mass and the support (34), the eighth end of each fifth beam being attached to the third frame and each sixth beam (72A, 72B) comprising a ninth end attached to the third frame and a tenth end connected to the mass.

11. The spring-mass system of any of claims 1 to 10, wherein the first frame follows a closed curve selected from the group comprising a rectangle, a circle, an ellipse, and a closed broken line.

**12.** An energy recovery device comprising the spring-mass system (30) of any of claims 1 to 11.

**13.** A seismometer comprising the spring-mass system (30) of any of claims 1 to 11.

**14.** An accelerometer comprising the spring-mass system (30) of any of claims 1 to 11.

**15.** An inclinometer comprising the spring-mass system (30) of any of claims 1 to 11.

**16.** A magnetometer comprising the spring-mass system (30) of any of claims 1 to 11 and wherein at least a portion of the mass (32) is formed of a ferromagnetic material and/or of a permanent magnet.

**17.** A force and/or displacement sensor comprising the spring-mass system (30) of any of claims 1 to 11.

Fig 1

Fig 2

Fig 3

Fig 4

Fig 5

Fig 6

Fig 7

Fig 8

Fig 9

Fig 10

Fig 11

Fig 12

Fig 13

**RÉFÉRENCES CITÉES DANS LA DESCRIPTION**

**Documents brevets cités dans la description**

- US 2012320439 A